(19) **Europäisches Patentamt**

**European Patent Office**

**Office européen des brevets**

(11) **EP 1 188 237 B1**

(12) **EUROPÄISCHE PATENTSCHRIFT**

(45) Veröffentlichungstag und Bekanntmachung des Hinweises auf die Patenterteilung:
**03.11.2004 Patentblatt 2004/45**

(21) Anmeldenummer: **00947779.5**

(22) Anmeldetag: **05.06.2000**

(51) Int Cl.⁷: **H03K 3/3562**

(86) Internationale Anmeldenummer:
**PCT/DE2000/001822**

(87) Internationale Veröffentlichungsnummer:
**WO 2000/076071 (14.12.2000 Gazette 2000/50)**

(54) **FLIPFLOP-SCHALTUNGSANORDNUNG**

FLIP-FLOP CIRCUIT

CIRCUITERIE A BASCULE

(84) Benannte Vertragsstaaten:
**DE**

(30) Priorität: **07.06.1999 DE 19925890**

(43) Veröffentlichungstag der Anmeldung:
**20.03.2002 Patentblatt 2002/12**

(73) Patentinhaber: **Infineon Technologies AG
81669 München (DE)**

(72) Erfinder: **TOHSCHE, Ulf
D-25524 Itzehoe (DE)**

(74) Vertreter: **Banzer, Hans-Jörg, Dipl.-Ing. et al
Kraus & Weisert
Patent- und Rechtsanwälte
Thomas-Wimmer-Ring 15
80539 München (DE)**

(56) Entgegenhaltungen:
**EP-A- 0 692 872          EP-A- 0 760 558**

- **SHARMA R ET AL: "A 6.75-NS 16X16-BIT MULTIPLIER IN SINGLE-LEVEL-METAL CMOS TECHNOLOGY" IEEE JOURNAL OF SOLID-STATE CIRCUITS,US,IEEE INC. NEW YORK, Bd. 24, Nr. 4, 1. August 1989 (1989-08-01), Seiten 922-927, XP000066218 ISSN: 0018-9200**
- **PATENT ABSTRACTS OF JAPAN vol. 009, no. 295 (E-360), 21. November 1985 (1985-11-21) -& JP 60 134623 A (TOSHIBA KK), 17. Juli 1985 (1985-07-17)**
- **"COMBINED SENSE AMPLIFIER AND LSSD LATCH" IBM TECHNICAL DISCLOSURE BULLETIN,US,IBM CORP. NEW YORK, Bd. 34, Nr. 10A, 1. März 1992 (1992-03-01), Seite 191 XP000302271 ISSN: 0018-8689**

EP 1 188 237 B1

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

**Beschreibung**

Die vorliegende Erfindung betrifft eine Flipflop-Schaltungsanordnung, insbesondere eine D-Flipflop-Schaltungsanordnung, nach dem Oberbegriff des Anspruches 1.

Flipflops oder bistabile Kippschaltungen sind Schaltungen mit einer Speicherwirkung, bei denen das Ausgangssignal sowohl von dem augenblicklichen Wert des Eingangssignals als auch von der Vorgeschichte abhängt. Aus diesem Grund werden Flipflops auch als sequentielle Schaltwerke bezeichnet.

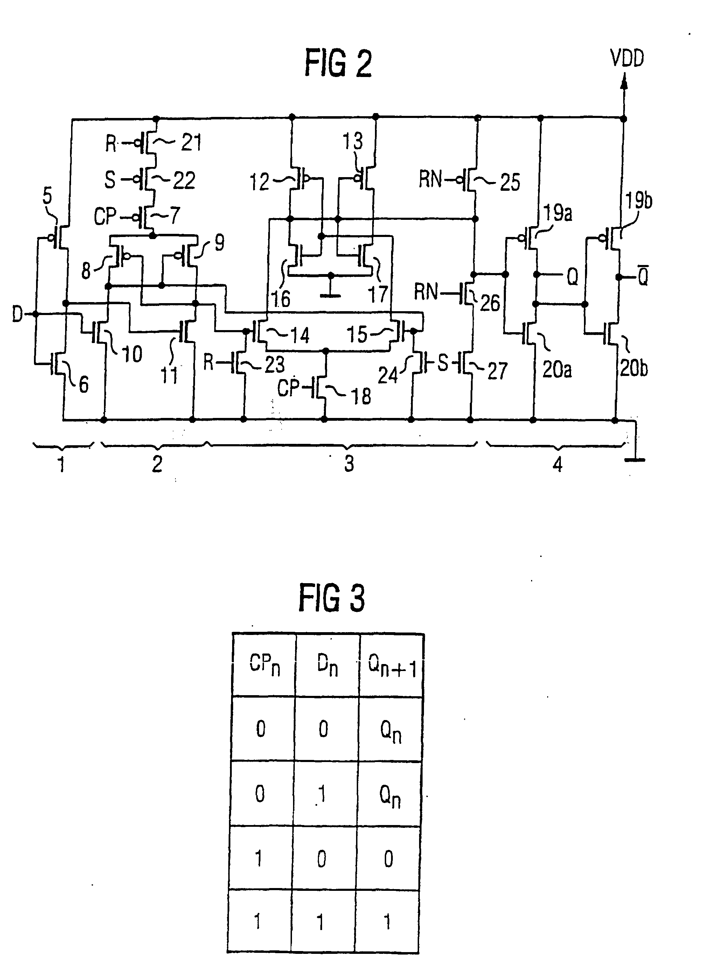

Ein D-Flipflop ist derart aufgebaut, daß es ein binäres Eingangssignal D empfängt, welches abhängig von einem angelegten Taktsignal CP an seinen Ausgang durchgeschaltet wird. In Fig. 6 ist die Wahrheitstabelle eines D-Flipflops dargestellt, wobei der Ausgangssignalwert $Q_{n+1}$ in Abhängigkeit von dem augenblicklichen Wert des Taktsignals $CP_n$ und dem augenblicklichen Wert des Eingangssignals $D_n$ dargestellt ist. Aus Fig. 3 ist ersichtlich, daß sich der Ausgangswert Q des D-Flipflops nur verändert, wenn das Taktsignal den binären Wert '1' besitzt, wobei in diesem Fall als Ausgangswert D der augenblickliche Wert des Eingangssignals D übernommen wird. In allen anderen Fällen bleibt der Ausgangswert Q des D-Flipflops unverändert. Das D-Flipflop kann entweder bei steigender Taktflanke oder bei fallender Taktflanke schaltend ausgestaltet sein.

Zur Realisierung von Flipflop-Schaltungen oder bistabilen Kippschaltungen bieten sich Transistoren als Schalter an. Bekannterweise kann eine Flipflop-Schaltung insbesondere aus einer Reihenschaltung von zwei galvanisch mitgekoppelten Invertern in CMOS-Technik aufgebaut sein.

Für viele Anwendungen, wie z.B. Zähler oder Schieberegister, sind jedoch die oben beschriebenen einfachen Flipflop-Schaltungen ungeeignet, da in diesen Fällen Flipflops benötigt werden, welche den Zustand des Eingangssignals zunächst zwischenspeichern und ihn erst dann an den Ausgang übertragen, wenn der Eingang des Flipflops wieder durch das Taktsignal 'verriegelt' ist.

Derartige Flipflop-Schaltungen bestehen daher aus zwei in Reihe geschalteten Flipflops oder Speicherzellen (Latch-Schaltungen), nämlich einem sogenannten Master-Latch und einem sogenannten Slave-Latch, und werden demzufolge auch als Master-Slave-Flipflops bezeichnet. Das Master-Latch empfängt an seinem Eingang das Eingangssignal D und ist mit seinem Ausgang mit dem Eingang des Slave-Latchs verbunden. Am Ausgang des Slave-Latchs kann das Ausgangssignal Q des Master-Slave-Flipflops abgegriffen werden. Das Master-Latch und das Slave-Latch werden mit Hilfe des Taktsignals CP komplementär zueinander geschaltet.

Ist beispielsweise der Takt CP = '0', wird der augenblickliche Wert des Eingangssignals D in das Master-Latch eingelesen und gespeichert. Der Ausgangszustand Q des Slave-Latchs bleibt zunächst unverändert, da das Slave-Latch durch das Taktsignal verriegelt ist. Wechselt anschließend das Taktsignal zu CP = '1', wird das Master-Latch blockiert und der augenblickliche und zuvor eingelesene Wert am Ausgang des Master-Latchs an den Ausgang des Slave-Latchs übertragen und als Ausgangssignalwert Q des Master-Slave-Flipflops ausgegeben. Bei derartigen Master-Slave-Flipflops gibt es demnach im Gegensatz zu einfachen Flipflop-Schaltungen keinen Taktzustand, bei dem sich das Eingangssignal D unmittelbar auf das Ausgangssignal Q auswirkt.

In der Druckschrift "New Single-Clock CMOS Latches and Flipflops with Improved Speed and Power Savings", Jiren Yuan und Christer Svensson, IEEE Journal of Solid-State Circuits, Vol. 32, Nr. 1, Januar 1997 , Seiten 62-69 ist eine Flipflop-Schaltungsanordnung nach dem Oberbegriff des Anspruches 1 offenbart. In dieser Druckschrift wird vorgeschlagen, ein Niedrigleistungs-D-Flipflop aus zwei in Reihe geschalteten differentiell arbeitenden D-Flipflops oder Speicherzellen (Latches) aufzubauen. Jedes Flipflop besteht aus einer Reihenschaltung von zwei galvanisch mitgekoppelten Invertern in CMOS-Technik. Insbesondere wird vorgeschlagen, das Master-Latch in Form eines differentiell arbeitenden p-Latchs und das Slave-Latch in Form eines ebenfalls differentiell arbeitenden n-Latchs aufzubauen. Die Ausgangssignale $Q, \bar{Q}$ werden direkt an internen Knoten des Slave-Latchs abgegriffen. Alternativ kann der Ausgang des Slave-Latchs auch mit einer abschließenden differentiellen Speicherzelle oder Latch-Schaltung verbunden sein. Auch in diesem Fall werden dann die Ausgangssignale $Q, \bar{Q}$ an den internen Knotenpunkten des die Flipflop-Schaltungsanordnung abschließenden differentiellen Latchs abgegriffen.

Das Abgreifen der Ausgangssignale $Q, \bar{Q}$ am internen Knoten des Slave-Latchs bzw. Slave-Latchs ist jedoch nachteilig, da die vom Flipflop-Ausgang zu treibenden Last das Slave-Latch beeinflußt und insbesondere dazu führt, daß das Slave-Latch langsamer schaltet und einen zeitlich lange fließenden Kurzschlußstrom über zumindest einen seiner beiden Inverter aufweist.

Weiterhin ist aus der EP-A-0 768 758 eine Flipflop-Schaltungsanordnung gemäß dem Oberbegriff des Anspruchs 1 bekannt. Die EP-A-0 768 758 beschreibt ein Master-Slave-Flipflop mit zwei in Serie geschalteten bistabilen Kippgliedern, wobei beiden Kippgliedern Schaltungsmittel zum Setzen bzw. Rücksetzten zugeordnet sind. Nachteiligerweise ist das beschriebene Master-Slave-Flipflop mit einer hohen Anzahl von Transistoren aufgebaut und besitzt daher eine hohe Leistungsaufnahme.

Der vorliegenden Erfindung liegt daher die Aufgabe zugrunde, eine Flipflop-Schaltungsanordnung mit niedrigem Leistungsbedarf zu schaffen, bei der zudem eine konstant hohe Schaltgeschwindigkeit des Slave-Latchs erzielt werden kann.

Diese Aufgabe wird erfindungsgemäß durch eine Flipflop-Schaltungsanordnung mit den Merkmalen des Anspruches 1 gelöst. Die abhängigen Ansprüche definieren vorteilhafte und bevorzugte Ausführungsformen der vorliegenden Erfindung.

Erfindungsgemäß wird der Ausgang der Flipflop-Schaltungsanordnung von den internen Knoten des Slave-Latchs dadurch getrennt, daß eine nicht-differentielle Ausgangstreiberschaltung zwischengeschaltet wird. Die Ausgangstreiberschaltung kann beispielsweise in Form einer Inverterschaltung ausgestaltet sein. Durch die Trennung der über den Ausgang zu treibenden Last von den internen Knoten des Slave-Latchs wird eine von der zu treibenden Ausgangslast unabhängige Schaltgeschwindigkeit des Slave-Latchs erzielt, die somit konstant hoch sein kann. Die von den internen Knoten des Slave-Latchs umzuladenden Kapazitäten sind somit bekannt und ermöglichen eine für alle Ausgangslasten gültige Optimierung der Dimensionierungen der verwendeten Feldeffekttransistoren, um einen möglichst geringen Leistungsverbrauch und eine möglichst hohe Schaltgeschwindigkeit zu erzielen.

Die erfindungsgemäße Flipflop-Schaltungsanordnung kommt insbesondere mit einer minimalen Anzahl von Takttransistoren, nämlich zwei Takttransistoren, aus. Da das Taktsignal in einer Flipflop-Schaltung dasjenige Signal mit den meisten Zustandswechseln ist, ist das Taktsignal allgemein hinsichtlich des Energieverbrauchs der Flipflop-Schaltung von besonderer Bedeutung.

Auch ansonsten weist die erfindungsgemäße Flipflop-Schaltungsanordnung weniger Transistoren als andere bisher bekannte Niedrigleistungs-Flipflop-Schaltungen auf und kann daher auf Chips kompakter realisiert werden. Dies betrifft insbesondere die Ausgestaltung des Master-Latchs. Der Takttransistor des Slave-Latchs, welcher die Übernahme des am Ausgang des Master-Latchs anliegenden Signalwerts triggert, befindet sich nahe am Ausgang der Schaltung, wodurch sich eine geringere Signalverzögerung ergibt, während bei einigen bisher bekannten Lösungen das Taktsignal in mehreren aufeinanderfolgenden Stufen verarbeitet wird.

Die Erfindung wird nachfolgend unter Bezugnahme auf die beigefügte Zeichnung anhand bevorzugter Ausführungsbeispiele näher erläutert.

Fig. 1 zeigt das Schaltbild eines ersten Ausführungsbeispiels der vorliegenden Erfindung,

Fig. 2 zeigt das Schaltbild eines zweiten Ausführungsbeispiels der vorliegenden Erfindung, und

Fig. 3 zeigt die Wahrheitstabelle eines D-Flipflops.

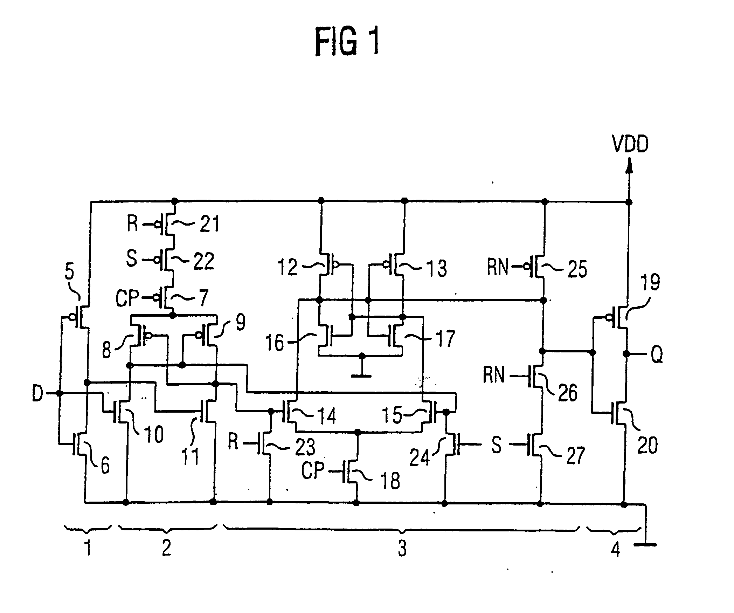

In Fig. 1 ist die Schaltung eines D-Fliflops dargestellt, bei dem die vorliegenden Erfindung angewendet ist.

Das in Fig. 1 gezeigte D-Flipflop ist in Form eines Master-Slave-Flipflops ausgestaltet und umfaßt eine Master-Latch-Schaltung 2 sowie eine damit in Reihe geschaltetes Slave-Latch-Schaltung 3, welche jeweils in CMOS-Technik ausgestaltet sind.

Sowohl das Master-Latch 2 als auch das Slave-Latch 3 umfaßt zwei galvanisch mitgekoppelte Transistor-Reihenschaltungen, welche im Master-Latch 2 durch einen p-Kanal Feldeffekttransistor 8 und einen n-Kanal Feldeffekttransistor 10 bzw. einen p-Kanal Feldeffekttransistor 9 und einen n-Kanal Feldeffekttransistor 11 gebildet sind, während sie in dem Slave-Latch 2 durch einen p-Kanal Feldeffekttransistor 12 und einen n-Kanal Feldeffekttransistor 14 bzw. einen p-Kanal Feldeffekttransistor 13 und einen n-Kanal Feldeffekttransistor 15 gebildet sind. Das Slave-Latch 2 umfaßt darüber hinaus entsprechend Fig. 1 verschaltete n-Kanal Feldeffekttransistoren 16 und 17, die zusammen mit den p-Kanal Feldeffekttransistoren 12 bzw. 13 jeweils einen CMOS-Inverter bilden.

Bei dem in Fig. 1 gezeigten Ausführungsbeispiel wird das Master-Latch 2 über einen gemäß Fig. 1 angeschlossenen p-Kanal Feldeffekttransistor 7 mit einem Taktsignal CP angesteuert, während das Taktsignal CP über einen n-Kanal Feldeffekttransistor 18 auch an das Slave-Latch 3 angelegt ist. Auf diese Weise werden die beiden Flipflops 2 und 3 komplementär zueinander getaktet, wobei bei CP = '0' das Master-Latch 2 aktiviert wird, während bei CP = '1' das Slave-Latch 3 aktiviert wird.

An das Master-Latch 2 bzw. dessen n-Kanal Feldeffekttransistor 10 ist das Eingangssignal D der D-Flipflop-Schaltung angelegt. Des weiteren ist eingangsseitig eine Inverterschaltung 1 mit einem p-Kanal Feldeffekttransistor 5 und einem damit in Reihe geschalteten n-Kanal Feldeffekttransistor 6 vorgesehen, dessen Ausgangssignal an den n-Kanal Feldeffekttransistor 11 angelegt ist, so daß dem Master-Latch 2 nicht nur das Eingangssignal D sondern auch das negierte Eingangssignal $\bar{D}$ zugeführt wird.

Am Ausgang des Slave-Latchs 3 tritt am Knotenpunkt zwischen den Transistoren 13 und 15 des Slave-Latchs 3 das Ausgangssignal Q und am Knotenpunkt zwischen den Transistoren 12 und 14 dessen negierter Wert $\bar{Q}$ auf.

Ist der Takt CP = '0', wird der augenblickliche Wert des Eingangssignals D in das Master-Latch 2 eingelesen und gespeichert. Der Ausgangszustand des Slave-Latchs bleibt zunächst unverändert, da das Slave-Latch durch das Taktsignal CP verriegelt ist. Wechselt anschließend das Taktsignal zu CP = '1', wird das Master-Latch 2 blockiert und der augenblickliche und zuvor eingelesene Wert am Ausgang des Master-Latchs 2 an den Ausgang des Slave-Latchs 3 übertragen.

Wie der in Fig. 1 gezeigten Schaltung entnommen werden kann, wird das Ausgangssignal Q nicht direkt an dem Ausgang des Slave-Latchs 3 abgegriffen, sondern über eine nicht-differentielle Ausgangstreiberschaltung 4 ausgegeben. Bei dem in Fig. 1 gezeigten Beispiel ist diese Ausgangstreiberschaltung 4 insbesondere in Form einer CMOS-Inverterschaltung mit einem p-Kanal Feldeffekttransistor 19 und einem n-Kanal Feldeffekttransistor 20 ausgebildet. Der Eingang dieser Inverterschaltung 4 greift am Knotenpunkt zwischen den Transistoren 12 und 14 an, wo der negierte Ausgangssignalwert $\overline{Q}$ auftritt, so daß von der Inverterschaltung 4 das Ausgangssignal Q über einen von den internen Knotenpunkten des Slave-Latchs 3 entkoppelten Ausgang ausgegeben wird.

In Fig. 2 ist eine auf dem erfindungsgemäßen Prinzip beruhende Flipflop-Schaltung mit invertiertem Ausgang und nichtinvertiertem Ausgang dargestellt. Analog zu Fig. 1 ist der Eingang einer ersten Inverterschaltung mit einem p-Kanal Feldeffekttransistor 19a und einem n-Kanal Feldeffekttransistor 20a mit dem Knotenpunkt zwischen den Transistoren 12 und 14 des Slave-Latchs 3 verbunden, so daß am Ausgang dieser Inverterschaltung der Ausgangssignalwert Q abgegriffen werden kann. Der Ausgang dieser ersten Inverterschaltung 19a, 20a ist zudem mit einem weiteren, identisch aufgebauten Inverter 19b, 20b verbunden, so daß an dessen Ausgang das invertierte Ausgangssignal $\overline{Q}$ abgegriffen werden kann. Auf diese Weise werden sowohl Q als auch $\overline{Q}$ über eine nicht-differentielle Ausgangstreiberschaltung 4 ohne direkte Verbindung mit den internen Knotenpunkten des Salve-Flipflops 3 ausgegeben, und die von dem D-Flipflop zu treibende Last ist von den internen Knotenpunkten des Slave-Fliflops 3 entkoppelt.

Beide Ausführungsbeispiele der vorliegenden Erfindung weisen eine Setz- (Set) und Rücksetzfunktion (Reset) auf. Zu diesem Zweck weist sowohl das Master-Latch 2 als auch das Slave-Latch 3 einen Eingang zum Anlegen eines Setzsignals S sowie einen Eingang zum Anlegen eines Rücksetzsignals R auf, wobei mit Hilfe des Setzsignals S das entsprechende Flipflop 2 bzw. 3 definiert auf den Wert '1' gesetzt werden kann, während mit Hilfe des Rücksetzsignals R das Flipflop 2 bzw. 3 definiert auf den Wert '0' gesetzt werden kann.

Gemäß Fig. 1 und 2 ist bezüglich des Master-Latchs 2 sowohl für das Setzsignal S als auch für das Rücksetzsignal R ein p-Kanal Feldeffekttransistor 22 bzw. 21 vorgesehen, der mit dem Takttransistor 7 in Reihe geschaltet ist. Für das Slave-Latch 3 sind hingegen n-Kanal Feldeffekttransistoren als Rücksetz-Feldeffekttransistor 23 und Setz-Feldeffekttransistor 24 vorgesehen, welche mit dem Gate-Anschluß des n-Kanal Feldeffekttransistors 14 bzw. 15 verbunden sind, um deren Gatespannung bei R = '1' bzw. S = '1' definiert auf den Wert '0' zu setzen. Des weiteren ist auch der Ausgang des Slave-Latchs 3 mit einer Setz- und Rücksetzfunktion versehen, wobei zu diesem Zweck die in Fig. 1 und 2 gezeigten Transistoren 25-27 vorgesehen sind, und der Knotenpunkt zwischen dem p-Kanal Feldeffekttransistor 25 und den n-Kanal Feldeffekttransistoren 26, 27 mit dem internen Knotenpunkt des Slave-Flipflops 3 zwischen den Transistoren 12 und 14 verbunden ist. An den p-Kanal Feldeffekttransistor 25 und den n-Kanal Feldeffekttransistor 26 ist jeweils das negierte Rücksetzsignal RN angelegt, während der n-Kanal Feldeffekttransistor das Setzsignal S empfängt. Die Transistoren 25-27, insbesondere der Transistor 26, dienen dazu, bei R = '1' und S = '1' dem Rücksetzsignal die Priorität einzuräumen, d.h. die Kombination R = '1' und S = '1' ist grundsätzlich zulässig. Wird auf den Transistor 26 verzichtet, wäre hingegen die Kombination R = '1' und S = '1' nicht zulässig. Nur bei der Kombination R = '0' und S = '0' wird von der Flipflop-Schaltung die eigentliche Funktion eines D-Flipflops ausgeführt (vgl. Fig. 3).

Die in den Fig. 1 und 2 gezeigten erfindungsgemäßen D-Flipflop-Schaltungen sind jeweils derart aufgebaut, daß sie mit einer minimalen Anzahl an Transistoren auskommen. Die Takttransistoren 7 und 18, welche jeweils die Übernahme des anliegenden Signalwerts an den entsprechenden Ausgang triggern, befinden sich beim tatsächlich realisierten Schaltungslayout in der Nähe des Ausgangs des entsprechenden Flipflops 2 bzw. 3, so daß lediglich geringe Verzögerungszeiten gewährleistet sind. Aufgrund einer besonderen Schaltungstechnik ist sichergestellt, daß in den dargestellten D-Flipflop-Schaltungen lediglich im Schaltfall, d.h. wenn sich das Eingangssignal D verändert, Energie verbraucht wird. Der von der Aktivität der Flipflop-Schaltung unabhängige offset im Leistungsverbrauch ist daher geringer als bei bekannten Lösungen und besteht lediglich aus der vom Taktnetz aufzubringenden Leistung zur Ansteuerung der Takttransistoren 7 und 18.

Im Vergleich zu bisher verwendeten Niedrigleistungs-D-Flipflops konnte bei den dargestellten Schaltungen das sogenannte Power-Delay-Produkt, d.h. das Produkt aus der Leistungsaufnahme und der Verzögerungszeit der Flipflop-Schaltung näherungsweise um 80% im statischen Fall (d.h. bei Q = konstant), um 49% bei mittlerer Aktivität der Flipflop-Schaltung und um 36% bei maximaler Aktivität (beispielsweise bei Einsatz der Flipflop-Schaltung als Frequenzteiler) verringert werden. Die Verzögerungszeit umfaßt dabei die Summe aus der sogenannten Setupzeit und der eigentlichen zeitlichen Verzögerung der Flipflop-Schaltung. Darüber hinaus konnte der Leistungsverbrauch im statischen Fall näherungsweise um 66% und bei mittlerer Aktivität um 16% reduziert werden. Die zuvor genannten Werte gelten jeweils für einen Ausgangspegelwahrscheinlichkeit von P(Q = 1) = 0,5. Geringere Ausgangspegelwahrscheinlichkeiten erhöhen die angegebenen Werte, wäh-rend umgekehrt geringere Ausgangspegelwahrschein-lichkeiten in gleichem Maße zu einer Verringerung der angegebenen Werte führen. Die Verzögerung der Flipflop-Schaltung, d.h. die Summe aus der Setupzeit und der eigentlichen Verzögerungszeit, konnte um ca. 39% reduziert werden, während der Flächenbedarf zur Realisierung der Flipflop-Schaltung um näherungsweise 6,6% verringert werden konnte.

**Patentansprüche**

1. Flipflop-Schaltungsanordnung,
   mit einer ersten Latch-Schaltung (2), an die ein binäres Eingabesignal (D) und ein binäres Taktsignal (CP) angelegt sind und die derart ausgestaltet ist, daß sie den anliegenden Eingabesignalwert (D) übernimmt und an ihren Ausgang durchschaltet, falls das Taktsignal (CP) einen ersten Zustand annimmt, und
   mit einer zweiten Latch-Schaltung (3), an die das Ausgangssignal der ersten Latch-Schaltung (2) und das Taktsignal (CP) angelegt sind und die derart ausgestaltet ist, daß sie den Ausgangssignalwert der ersten Flipflop-Schaltung (2) übernimmt und als Ausgabesignalwert ($Q,\bar{Q}$) der Flipflop-Schaltungsanordnung ausgibt, falls das Taktsignal (CP) einen zweiten Zustand annimmt,
   wobei mit dem Ausgang der zweiten Latch-Schaltung (3) eine nicht-differentielle Ausgangstreiberschaltung (4) verbunden ist, über welche der Ausgabesignalwert ($Q,\bar{Q}$) der Flipflop-Schaltungsanordnung ausgegeben wird,
   die erste und zweite Latch-Schaltung (2; 3) jeweils eine bistabile CMOS-Kippschaltung (8-11; 12-17) mit einem damit gekoppelten Steuer-Feldeffekttransistor (7; 18) ist, an den das Taktsignal (CP) angelegt ist, und
   Schaltungsmittel (21, 22; 23-27) zum Setzen und Rücksetzen der entsprechenden Latch-Schaltung (2; 3) umfassen,
   die bistabile CMOS-Kippschaltungen der ersten und zweiten Latch-Schaltung (2; 3) jeweils eine Parallelschaltung von zwei Reihenschaltungen eines p-Kanal Feldeffekttransistors (8, 9; 12, 13) mit einem n-Kanal Feldeffekttransistor (10, 11; 14, 15) umfassen, wobei jeweils die Steueranschlüsse des p-Kanal Feldeffekttransistors (8, 9; 12, 13) der einen Reihenschaltung mit dem Knotenpunkt der anderen Reihenschaltung verbunden ist,
   **dadurch gekennzeichnet,**
   **daß** die Schaltungsmittel (23-27) zum Setzen und Rücksetzen der zweiten Latch-Schaltung (3) einen Rücksetz-Feldeffekttransistor (23), der zwischen dem Steueranschluss des n-Kanal Feldeffekttransistors (14) der ersten Reihenschaltung der zweiten Latch-Schaltung (3) und dem Bezugspotential der Flipflop-Schaltungsanordnung geschaltet ist und an den ein Rücksetzsignal (R) angelegt ist, und einen Setz-Feldeffekttransistor (24), der zwischen dem Steueranschluss des n-Kanal Feldeffekttransistors (15) der zweiten Reihenschaltung der zweiten Latch-Schaltung (3) und dem Bezugspotential der Flipflop-Schaltungsanordnung geschaltet ist und an den ein Setzsignal (S) angelegt ist, umfassen.

2. Flipflop-Schaltungsanordnung nach Anspruch 1,
   **dadurch gekennzeichnet,**
   **daß** die nicht-differentielle Ausgangstreiberschaltung (4) eine Inverterschaltung (19, 20) ist, deren Eingang mit dem Ausgang der zweiten Latch-Schaltung (3) verbunden ist, wobei der Ausgabesignalwert ($Q,\bar{Q}$) der Flipflop-Schaltungsanordnung über den Ausgang der Inverterschaltung (19, 20) ausgegeben wird.

3. Flipflop-Schaltungsanordnung nach Anspruch 1,
   **dadurch gekennzeichnet,**
   **daß** die nicht-differentielle Ausgangstreiberschaltung (4) eine erste Inverterschaltung (19a, 20a) und eine zweite Inverterschaltung (19b, 20b) umfaßt, wobei der Eingang der ersten Inverterschaltung (19a, 20a) mit dem Ausgang der zweiten Latch-Schaltung (3) und der Eingang der zweiten Inverterschaltung (19b, 20b) mit dem Ausgang der ersten Inverterschaltung (19a, 20a) verbunden ist und der Ausgabesignalwert ($Q;\bar{Q}$) der Flipflop-Schaltungsanordnung über den Ausgang der ersten Inverterschaltung (19a, 20a) und der negierte Ausgabesignalwert ($\bar{Q};Q$) der Flipflop-Schaltungsanordnung über den Ausgang der zweiten Inverterschaltung (19b, 20b) ausgegeben wird.

4. Flipflop-Schaltungsanordnung nach einem der vorhergehenden Ansprüche,
   **dadurch gekennzeichnet,**
   **daß** die Schaltungsmittel zum Setzen und Rücksetzen der ersten Latch-Schaltung (2) einen mit dem Steuer-Feldeffekttransistor (7) in Reihe geschalteten weiteren Steuer-Feldeffekttransistor (22), an den ein Setzsignal (S) angelegt ist, und einen damit in Reihe geschalteten weiteren Steuer-Feldeffekttransistor (21), an den ein Rücksetzsignal (R) angelegt ist, umfassen.

5. Flipflop-Schaltungsanordnung nach Anspruch 4,
   **dadurch gekennzeichnet,**
   **daß** die Steuer-Feldeffekttransistoren (21, 22) der ersten Latch-Schaltung (2) p-Kanal Feldeffekttransistoren sind.

6. Flipflop-Schaltungsanordnung nach einem der vorhergehenden Ansprüche,
   **dadurch gekennzeichnet,**
   **daß** die Schaltungsmittel zum Setzen und Rücksetzen der zweiten Latch-Schaltung (3) eine mit den Ausgang der zweiten Latch-Schaltung (3) gekoppelte Reihenschaltung eines weiteren Steuer-Feldeffekttransistors (26), an den das negierte Rücksetzsignal (RN) angelegt ist, und eines weiteren Steuer-Feldeffekttransistors (27), an den das Setzsignal (S) angelegt ist, umfassen.

7. Flipflop-Schaltungsanordnung nach Anspruch 6,
**dadurch gekennzeichnet,**
**daß** die Steuer-Feldeffekttransistoren der zweiten Flipflop-Schaltung (3) n-Kanal Feldeffekttransistoren sind.

8. Flipflop-Schaltungsanordnung nach Anspruch 7,
**dadurch gekennzeichnet,**
**daß** zudem mit dem Ausgang der zweiten Latch-Schaltung (3) ein p-Kanal Steuer-Feldeffekttransistor (25) angeschlossen ist, an den das negierte Rücksetzsignal (RN) angelegt ist.

**Claims**

1. Flip-flop circuit,
having a first latch circuit (2) to which a binary input signal (D) and a binary clock signal (CP) are applied and which is so designed that it accepts the input signal value (D) applied and switches it through to its output if the clock signal (CP) is in a first state, and
having a second latch circuit (3) to which the output signal of the first latch circuit (2) and the clock signal (CP) are applied and which is so designed that it accepts the output signal value from the first flip-flop circuit (2) and emits it as the output signal value $(Q,\overline{Q})$ of the flip-flop circuit if the clock signal (CP) is in a second state,
wherein connected to the output of the second latch circuit (3) is a non-differential output driver circuit (4) from which the output signal value $(Q,\overline{Q})$ of the flip-flop circuit is emitted,
wherein the first and second latch circuits (2, 3) are each bistable CMOS latch circuits (8-11, 12-17) having coupled to them controlling field-effect transistors (7, 18) to which the clock signal (CP) is applied and comprising switching means (21, 22; 23-27) for setting and resetting the corresponding latch circuits (2, 3),
wherein the bistable CMOS latch circuits forming the first and second latch circuits (2, 3) each comprise, connected in parallel, two circuits each comprising a p-channel field-effect transistor (8, 9; 12, 13) connected in series with an n-channel field-effect transistor (10, 11; 14, 15), the control connections of the p-channel field-effect transistors (8, 9; 12, 13) of one series circuit being connected in each case to the node of the other series circuit,
**characterised in that**
the switching means (23-27) for setting and resetting the second latch circuit (3) comprise a resetting field-effect transistor (23), which is connected between the control connection of the n-channel field-effect transistor (14) of the first series circuit of the second latch circuit (3) and the reference potential of the flip-flop circuit and to which a resetting signal (R) is applied, and a setting field-effect transistor (24), which is connected between the control connection of the n-channel field-effect transistor (15) of the second series circuit of the second latch circuit (3) and the reference potential of the flip-flop circuit and to which a setting signal (S) is applied.

2. Flip-flop circuit according to claim 1,
**characterised in that**
the non-differential output driver circuit (4) is an inverter circuit (19, 20) whose input is connected to the output of the second latch circuit (3), the output signal value $(Q,\overline{Q})$ of the flip-flop circuit being emitted from the output of the inverter circuit (19, 20).

3. Flip-flop circuit according to claim 1,
**characterised in that**
the non-differential output driver circuit (4) comprises a first inverter circuit (19a, 20a) and a second inverter circuit (19b, 20b), the input of the first inverter circuit (19a, 20a) being connected to the output of the second latch circuit (3) and the input of the second inverter circuit (19b, 20b) being connected to the output of the first inverter circuit (19a, 20a) and the output signal value $(Q,\overline{Q})$ of the flip-flop circuit being emitted from the output of the first inverter circuit (19a, 20a) and the negated output signal value $(\overline{Q},Q)$ of the flip-flop circuit being emitted from the output of the second inverter circuit (19b, 20b).

4. Flip-flop circuit according to one of the foregoing claims,
**characterised in that**
the switching means for setting and resetting the first latch circuit (2) comprise a further controlling field-effect transistor (22) which is connected in series with the controlling field-effect transistor (7) and to which a setting signal (S) is applied, and a further controlling field-effect transistor (21) which is connected in series with the latter and to which a resetting signal (R) is applied.

5. Flip-flop circuit according to claim 4,
**characterised in that**
the controlling field-effect transistors (21, 22) in the first latch circuit (2) are p-channel field-effect transistors.

6. Flip-flop circuit according to one of the foregoing claims,
**characterised in that**
the switching means for setting and resetting the second latch circuit (3) comprise a circuit comprising a further controlling field-effect transistor (26), to which the negated resetting signal (RN) is applied, connected in series with a further controlling field-effect transistor (27) to which the setting signal (S) is applied, which circuit is coupled to the output of the second latch circuit (3).

7. Flip-flop circuit according to claim 6, **characterised in that** the controlling field-effect transistors in the second flip-flop circuit (3) are n-channel field-effect transistors.

8. Flip-flop circuit according to claim 7, **characterised in that** also connected to the output of the second latch circuit (3) is a p-channel controlling field-effect transistor (25) to which the negated resetting signal (RN) is applied.

**Revendications**

1. Installation de circuit à bascule, comportant un premier circuit de verrouillage (2) auquel un signal d'entrée binaire (D) et un signal d'horloge binaire (CP) sont fournis et qui est configuré de façon qu'il réceptionne la valeur du signal d'entrée amené (D) et le relie à sa sortie, si le signal d'horloge (CP) prend un premier état, et comportant un deuxième circuit de verrouillage (3) auquel le signal de sortie du premier circuit de verrouillage (2) et le signal d'horloge (CP) sont fournis et qui est configuré de façon qu'il réceptionne la valeur du signal de sortie du premier circuit à bascule (2) et l'émet en tant que valeur de signal de sortie $(Q,\overline{Q})$ de l'installation de circuit à bascule si le signal d'horloge (CP) prend un deuxième état, dans lequel un circuit d'excitation de sortie non différentiel (4), par lequel la valeur de signal de sortie $(Q, \overline{Q})$ de l'installation de circuit à bascule est émis, est relié à la sortie du deuxième circuit de verrouillage (3), le premier et le deuxième circuits de verrouillage (2 ; 3) sont respectivement un circuit à bascule CMOS bistable (8-11 ; 12-17) avec un transistor de commande à effet de champ (7 ; 18) couplé à celui-ci, auquel le signal d'horloge (CP) est fourni, et comprennent des moyens de commutation (21, 22 ; 23-27) pour initialiser et réinitialiser le circuit de verrouillage correspondant (2 ; 3), les circuits à bascule CMOS bistables du premier et du deuxième circuits de verrouillage (2 ; 3) comprennent respectivement un circuit parallèle de deux circuits série d'un transistor à effet de champ à canal p (8, 9 ; 12, 13) avec un transistor à effet de champ à canal n (10, 11 ; 14, 15), où chacune des bornes de commande du transistor à effet de champ à canal p (8, 9 ; 12, 13) d'un circuit série est reliée au noeud de l'autre circuit série, **caractérisée en ce que** les moyens de commutation (23-27) pour initialiser et réinitialiser le deuxième circuit de verrouillage (3) comprennent un transistor à effet de champ de réinitialisation (23), qui est monté entre la borne de commande du transistor à effet de champ à canal n (14) du premier circuit série du deuxième circuit de verrouillage (3) et le potentiel de référence de l'installation de circuit à bascule et auquel un signal de réinitialisation (R) est fourni, et un transistor à effet de champ d'initialisation (24), qui est monté entre la borne de commande du transistor à effet de champ à canal n (15) du deuxième circuit série du deuxième circuit de verrouillage (3) et le potentiel de référence de l'installation de circuit à bascule et auquel un signal d'initialisation (S) est fourni.

2. Installation de circuit à bascule selon la revendication 1, **caractérisée en ce que** le circuit d'excitation de sortie non différentiel (4) est un circuit inverseur (19, 20), dont l'entrée est reliée à la sortie du deuxième circuit de verrouillage (3), et la valeur de signal de sortie $(Q, \overline{Q})$ de l'installation de circuit à bascule est émise par la sortie du circuit inverseur (19, 20).

3. Installation à circuit à bascule selon la revendication 1, **caractérisée en ce que** le circuit d'excitation de sortie non différentiel (4) comprend un premier circuit inverseur (19a, 20a) et un deuxième circuit inverseur (19b, 20b), l'entrée du premier circuit inverseur (19a, 20a) est reliée à la sortie du deuxième circuit de verrouillage (3) et l'entrée du deuxième circuit inverseur (19b, 20b) est reliée à la sortie du premier circuit inverseur (19a, 20a), et la valeur du signal de sortie $(Q, \overline{Q})$ de l'installation de circuit à bascule est émise par la sortie du premier circuit inverseur (19a, 20a) et la valeur de signal de sortie logiquement inversée $(\overline{Q}, Q)$ de l'installation de circuit à bascule est émise par la sortie du deuxième circuit inverseur (19b, 20b).

4. Installation de circuit à bascule selon l'une quelconque des revendications précédentes, **caractérisée en ce que** les moyens de commutation pour initialiser et réinitialiser le premier circuit de verrouillage (2) comprennent un autre transistor de commande à effet de champ (22) monté en série avec le transistor de commande à effet de champ (7), auquel un signal d'initialisation (S) est fourni, et un autre transistor de commande à effet de champ (21) monté en série avec celui-ci, auquel un signal de réinitialisation (R) est fourni.

5. Installation de circuit à bascule selon la revendication 4, **caractérisée en ce que** les transistors de commande à effet de champ (21, 22) du premier circuit de verrouillage (2) sont des transistors à effet de champ à canal p.

6. Installation de circuit à bascule selon l'une quelconque des revendications précédentes, **caractérisée**

**en ce que** les moyens de commutation pour initialiser et réinitialiser le deuxième circuit de verrouillage (3) comprennent un circuit série, couplé à la sortie du deuxième circuit de verrouillage (3), d'un autre transistor à effet de champ de commande (26), auquel le signal de réinitialisation logiquement inversé (RN) est fourni, et d'un autre transistor à effet de champ de commande (27) auquel le signal d'initialisation (S) est fourni.

7.  Installation de circuit à bascule selon la revendication 6, **caractérisée en ce que** les transistors de commande à effet de champ du deuxième circuit de verrouillage (3) sont des transistors à effet de champ à canal n.

8.  Installation de circuit à bascule selon la revendication 7, **caractérisée en ce que**, en outre, un transistor de commande à effet de champ à canal p (25), auquel le signal de réinitialisation logiquement inversé (RN) est fourni, est connecté à la sortie du deuxième circuit de verrouillage (3).

# FIG 1

# FIG 2

# FIG 3

| $CP_n$ | $D_n$ | $Q_{n+1}$ |
|--------|-------|-----------|
| 0 | 0 | $Q_n$ |
| 0 | 1 | $Q_n$ |
| 1 | 0 | 0 |
| 1 | 1 | 1 |